Europäisches Patentamt

(19) European Patent Office

Office européen des brevets

(11) Numéro de publication: **0 068 571 B1**

(12) **FASCICULE DE BREVET EUROPEEN**

(45) Date de publication du fascicule du brevet:
**16.10.85**

(51) Int. Cl.⁴: **H 03 D 3/00, H 04 N 11/18**

(21) Numéro de dépôt: **82200756.3**

(22) Date de dépôt: **18.06.82**

(54) **Circuit numérique de démodulation d'un signal modulé en fréquence, application de ce circuit à la réalisation d'un étage de démodulation du signal de chrominance d'un récepteur de télévision, et récepteur de télévision équipé d'un tel étage.**

(30) Priorité: **24.06.81 FR 8112412**

(43) Date de publication de la demande:
**05.01.83 Bulletin 83/1**

(45) Mention de la délivrance du brevet:
**16.10.85 Bulletin 85/42**

(84) Etats contractants désignés:
**BE DE FR GB IT**

(56) Documents cités:
**EP - A - 0 029 376**
**FR - A - 2 219 570**
**US - A - 4 090 145**

**ELECTRONICS LETTERS, vol.15, no.16, 2 août 1979, Londres (GB) F.G.A. COUPE: "Digital frequency discriminator", pages 489, 490**

(73) Titulaire: **Laboratoires d'Electronique et de Physique Appliquée L.E.P., 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **BE DE GB IT**

(72) Inventeur: **Le Floch, Gérard, Société civile S.P.I.D. 209 rue de l'Université, F-75007 Paris (FR)**

(74) Mandataire: **Landousy, Christian et al, Société Civile S.P.I.D. 209, Rue de l'Université, F-75007 Paris (FR)**

## Description

La présente invention concerne un circuit numérique de démodulation d'un signal modulé en fréquence, ainsi qu'une application d'un tel circuit à la réalisation d'un étage de démodulation du signal de chrominance d'un récepteur de télévision; elle concerne également, bien entendu, tout récepteur de télévision équipé d'un tel étage de démodulation.

Le but de l'invention est, plus précisément, de proposer un circuit qui comprend des moyens originaux de démodulation opérant par reconstitution d'un signal proportionnel à la fréquence instantanée du signal d'entrée modulé, à partir de l'expression de la dérivée de ce signal d'entrée.

L'invention concerne, à cet effet, un circuit numérique de démodulation d'un signal modulé en fréquence comprenant un convertisseur analogique-numérique d'un signal à traiter dont la sortie se divise en deux voies parallèles, un circuit d'horloge, et un opérateur auquel aboutissent ces deux voies et qui délivre sur sa sortie un signal proportionnel à ladite valeur de fréquence, caractérisé en ce que, pour déterminer la fréquence d'un signal ayant subi une modulation de sa fréquence selon la relation
$X(t) = A \cdot \sin(\omega_o t + \int_0^t f(t) \cdot dt + \varphi_o)$
dans laquelle $\omega_o$ est la pulsation de la porteuse et $f(t)$ le signal de modulation, lesdites voies comprennent un premier étage de détermination de la dérivée
$X'(t) = A \cdot (\omega_o + f(t) \cdot \cos(\omega_o t + \int_0^t f(t) \cdot dt + \varphi_o)$
du signal d'entrée, pour des instants déterminés se succédant au rythme d'une cadence de période T, et un deuxième étage de détermination des valeurs de la fonction
$M = 1/A \cdot \cos(\omega_o t + \int_0^t f(t) \cdot dt + \varphi_o)$
aux mêmes instants déterminés, et en ce que ledit opérateur est un circuit de multiplication des signaux délivrés par ces premier et deuxième étages, ce circuit de multiplication restituant un signal numérique
$X'(t) \cdot M = f(t) + \omega_o$
proportionnel à la fréquence instantanée du signal d'entrée modulé en fréquence.

La reconstitution recherchée est donc obtenue à l'aide d'une structure qui, étant donné l'expression générale de la dérivée d'une fonction et la possibilité d'isoler dans une telle expression celle qui donne la fréquence instantanée du signal d'entrée modulé, permet de déterminer séparément, à une cadence déterminée commandant la précision de la démodulation, les valeurs numériques instantanées successives des composantes de cette expression de la fréquence instantanée.

La demande de brevet français n° 7 306 380 publiée sous le n° 2 219 570 décrit un dispositif discriminateur de fréquence présentant une structure qui pourrait paraître similaire à celle qui est proposée dans la présente demande, en ce sens que le dispositif, selon ce document, comprend un convertisseur analogique-numérique dont la sortie se divise en deux voies parallèles, un opérateur auquel aboutissent ces deux voies et qui délivre sur ses sorties notamment une valeur de fréquence, et un circuit d'horloge. En fait, les circuits placés dans ces voies et à leur sortie sont différents de ceux prévus dans le cas de la présente invention, qui concourent en outre à un but différent, la démodulation d'un signal modulé en fréquence.

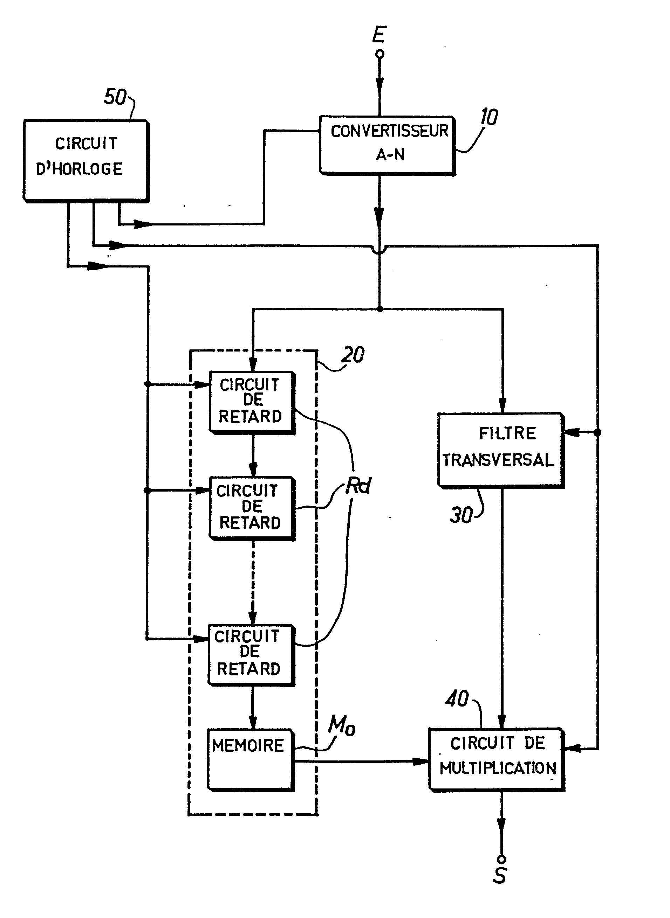

D'autres particularités et avantages de ladite invention apparaîtront maintenant de façon plus détaillée dans la description qui va suivre et dans la figure annexée, donnée à titre d'exemple non limitatif et qui représente un exemple de réalisation du circuit conforme à l'invention.

Dans un premier exemple de réalisation, qui est celui représenté sur la figure, le circuit selon l'invention comprend un convertisseur analogique-numérique 10 qui reçoit le signal d'entrée modulé en fréquence et, en sortie de ce convertisseur et en parallèle l'une sur l'autre, deux voies distinctes consistant en deux étages 20 et 30 de détermination de valeur numérique, un circuit 40 assurant la multiplication des signaux correspondants délivrés par ces deux étages et restituant ainsi un signal numérique de sortie qui est proportionnel à la fréquence instantanée du signal d'entrée modulé en fréquence.

En effet, si, $\omega_o$ étant la pulsation porteuse et $f(t)$ le signal de modulation, le signal d'entrée modulé est de la forme:

$$X = A \sin[\omega_o t + \int_0^t f(t) \cdot dt + \varphi_o] \qquad (1)$$

(ou de la forme similaire obtenue avec un cosinus), la dérivée de cette fonction est de la forme:

$$X' = A \cos[\omega_o t + \int_0^t f(t) \cdot dt + \varphi_o] \cdot [\omega_o + f(t)] \qquad (2)$$

La détermination de la dérivée $X'$ et celle de la fonction
$M = 1/A \cos[\omega_o t + \int_0^t f(t) \cdot dt + \varphi_o]$
permettent alors d'obtenir l'expression du signal de modulation
$f(t) = (X' \cdot M) - \omega_o$
(le signe de M étant, dans le cas présent, donné par celui de $X'$). Dans la réalisation décrite, l'étage 20, destiné à la détermination de la valeur numérique de la fonction M comprend plusieurs registres à décalage $R_d$, devant retarder le signal d'entrée de l'étage 20 d'une durée qui est précisée ci-dessous, et une mémoire numérique $M_o$ qui contient, pour chaque valeur particulière du signal d'entrée résultant de l'échantillonnage effectué par le convertisseur 10, une valeur particulière correspondante de la fonction M (cette mémoire $M_o$ contient donc, en fait, une table des valeurs de M, les adresses de ces valeurs étant fournies par la fonction sinusoïdale d'entrée). L'étage 30, destiné à la détermination de la valeur numérique de la dérivée du signal d'entrée pour ces mêmes valeurs particulières du signal d'entrée, est un filtre transversal linéaire à N circuits de retard, N étant pair.

Pour assurer la synchronisation des résultats correspondants des déterminations de la fonction M et de la dérivée du signal d'entrée, effectuées par les premier et deuxième étages 30 et 20, le retard global apporté au signal au cours de la traversée de l'étage 20 doit être égal à $(N-1)/2$ fois le retard T de chaque circuit de retard élémentaire du filtre transversal (en effet, dans un filtre transversal, le retard du signal de sortie par rapport au signal d'entrée est de façon connue donné par l'expression $(N-1)T/2$). Si l'on a par exemple $N = 6$, ce retard est égal à 2,5 fois le retard unitaire T des circuits de retard du filtre transversal (qui sont des registres à décalage). Cela implique que, si la cadence de fonctionnement des étages 20 et 30 est donnée par la fréquence $F = 1/T$, ces cadences, identiques, doivent cependant être décalées d'une demi-période de l'une par rapport à l'autre pour pouvoir obtenir le retard 2,5 T, et donc que la cadence d'échantillonnage du convertisseur 10 soit donnée par la fréquence 2F double de celle des étages 20 et 30.

Dans un deuxième exemple de réalisation, non représenté, le nombre N des circuits de retard du filtre transversal peut cette fois être choisi impair; le retard global apporté au signal qui traverse l'étage 20 de détermination de valeur numérique est alors égal, par application de la même formule que ci-dessus, à un nombre entier de fois le retard unitaire T des circuits de retard du filtre transversal (avec $N = 11$ par exemple, cinq fois ce retard unitaire). Cela implique cette fois-ci que les cadences de fonctionnement des étages 20 et 30 sont non seulement identiques mais synchrones, et que la cadence de fonctionnement peut être la même pour le convertisseur 10 et pour les premier et deuxième étages 30 et 20. Un avantage de ce deuxième mode de réalisation est maintenant manifeste: pour un même retard unitaire T, la fréquence d'échantillonnage $F = 1/T$ fixée par le circuit d'horloge 50 est deux fois plus faible que dans le cas du premier mode de réalisation. Ce deuxième mode de réalisation exige cependant un nombre de registres à décalage sensiblement supérieur à celui du premier, mais en contre-partie, une réduction de ce nombre peut être opérée si les circuits de retard du deuxième étage 20 sont constitués par les premiers circuits de retard du premier étage 30.

Bien entendu, la présente invention n'est pas limitée à ces exemples de réalisation, à partir desquels d'autres variantes peuvent être proposées sans pour cela sortir du cadre ou de l'esprit de l'invention. On peut notamment utiliser le circuit conforme à l'invention pour la réalisation d'un étage numérique de démodulation du signal de chrominance (modulé en fréquence) d'un récepteur de télévision; l'invention concerne aussi, alors, tout récepteur de télévision qui est équipé d'un tel étage de démodulation. Il est bien manifeste, cependant, que l'invention ne s'applique pas seulement au cas de la télévision, mais concerne de façon très générale tout problème de démodulation de fréquence.

Dans le cas des exemples de réalisation ici décrits, il est possible d'inclure dans le circuit d'horloge 50 un circuit d'inhibition destiné à permettre l'élimination, en sortie du circuit de multiplication 40, des valeurs de signal qui correspondent à des valeurs asymptotiques de la fonction M et qui conduisent à d'importantes erreurs de démodulation.

## Revendications

1. Circuit numérique de démodulation d'un signal modulé en fréquence comprenant un convertisseur analogique-numérique (10) d'un signal à traiter dont la sortie se divise en deux voies parallèles, un circuit d'horloge (50), et un opérateur auquel aboutissent ces deux voies et qui délivre sur sa sortie un signal proportionnel à ladite valeur de fréquence, caractérisé en ce que, pour déterminer la fréquence d'un signal ayant subi une modulation de sa fréquence selon la relation
$X(t) = A \cdot \sin(\omega_o t + \int_0^t f(t) \cdot dt + \varphi_o)$
dans laquelle $\omega_o$ est la pulsation de la porteuse et $f(t)$ le signal de modulation, lesdites voies comprennent un premier étage (30) de détermination de la dérivée
$X'(t) = A \cdot (\omega_o + f(t)) \cdot \cos(\omega_o t + \int_0^t f(t) \cdot dt + \varphi_o)$
du signal d'entrée, pour des instants déterminés se succédant au rythme d'une cadence de période de T, et un deuxième étage (20) de détermination des valeurs de la fonction
$M = 1/A \cdot \cos(\omega_o t + \int_0^t f(t) \cdot dt + \varphi_o)$
aux mêmes instants déterminés, et en ce que ledit opérateur est un circuit (40) de multiplication des signaux délivrés par ces premier et deuxième étages (30) et (20), ce circuit de multiplication restituant un signal numérique
$X'(t) \cdot M = f(t) + \omega_o$
proportionnel à la fréquence instantanée du signal d'entrée modulé en fréquence.

2. Circuit selon la revendication 1, caractérisé en ce que le premier étage (30) est un filtre transversal linéaire à N circuits de retard élémentaires et en ce que le deuxième étage (20) comprend d'une part des circuits de retard ($R_d$) destinés à délivrer des échantillons du signal $X(t)$ retardés d'une durée égale au retard apporté dans l'autre voie par ledit filtre transversal linéaire et d'autre part une mémoire numérique ($M_o$) recevant en adresse lesdits échantillons retardés et délivrant sur une entrée du circuit de multiplication (40) des données numériques en phase avec celles issues du filtre transversal linéaire et fournies à l'autre entrée dudit circuit de multiplication.

3. Circuit selon l'une des revendications 1 et 2, caractérisé en ce que la commande effectuée par le circuit d'horloge (50) est prévue pour éliminer en sortie du circuit de multiplication (40) les valeurs de signal qui correspondraient à des valeurs asymptotiques de la fonction M.

4. Circuit selon l'une des revendications 2 et 3, caractérisé en ce que le nombre N de circuits de retard du filtre transversal est pair, et en ce que le circuit d'horloge (50) impose aux circuits de retard des premier et deuxième étages de détermination de valeur numérique des cadences de fonctionnement identiques mais avec décalage d'une demi-période de l'une par rapport à l'autre.

5. Circuit selon l'une des revendications 2 et 3, caractérisé en ce que le nombre N de circuits de retard du filtre transversal est impair, et en ce que le circuit d'horloge (50) impose aux circuits de retard des premier et deuxième étages de détermination de valeur numérique des cadences de fonctionnement identiques et synchrones.

6. Circuit selon la revendication 5, caractérisé en ce que les circuits de retard du deuxième étage de détermination de valeur numérique sont constitués par les premiers circuits de retard du premier étage de détermination de valeur numérique.

7. Application du circuit selon l'une des revendications 1 à 6 à la réalisation d'un étage numérique de démodulation du signal de chrominance d'un récepteur de télévision.

8. Récepteur de télévision caractérisé en ce qu'il comprend un étage numérique de démodulation du signal de chrominance selon la revendication 7.

**Patentansprüche**

1. Digitale Demodulationsschaltung für ein frequenzmoduliertes Signal mit einem Analog-Digital-Wandler (10) zum Umsetzen eines zu bearbeitenden Signals, wobei der Wandlerausgang sich in zwei parallel verlaufende Signalwege aufteilt, mit einem Taktgeber (50) und einem Prozessor, in den diese Signalwege münden und der ein dem Frequenzwert proportionales Ausgangssignal liefert, dadurch gekennzeichnet, dass zur Frequenzbestimmung eines Signals, das entsprechend der Gleichung
$$X(t) = A \cdot \sin (\omega_o t + \int_0^t f(t) \cdot dt + \varphi_o)$$
frequenzmoduliert wurde, wobei $\omega_o$ die Trägerfrequenz und $f(t)$ das Modulationssignal ist, die Signalwege eine erste Stufe (30) zur Ermittlung der Abteilung
$$X'(t) = A \cdot (\omega_o + f(t)) \cdot \cos (\omega_o t + \int_0^t f(t) \cdot dt + \varphi_o)$$
des Eingangssignals zu bestimmten im Takt eines Zeitintervalls T aufeinanderfolgenden Zeitpunkten und eine zweite Stufe (20) zur Ermittlung der Werte der Funktion
$$M = 1/A \cdot \cos (\omega_o t + \int_0^t f(t) \cdot dt + \varphi_o)$$
zu denselben bestimmten Zeitpunkten enthalten und dass der Prozessor eine Multiplikationsschaltung (40) für die Ausgangssignale dieser ersten und zweiten Stufen (30) und (20) ist und ein digitales Signal
$$X'(t) \cdot M = f(t) + \omega_o$$
proportional der momentanen Frequenz des frequenzmodulierten Eingangssignals erzeugt.

2. Demodulationsschaltung nach Anspruch 1, dadurch gekennzeichnet, dass die erste Stufe (30) ein lineares Transversalfilter mit N elementaren Verzögerungsschaltungen ist und die zweite Stufe (20) einerseits Verzögerungsschaltungen $(R_d)$ zur Lieferung von Abtastwerten des Signals X(t), die um eine Zeit gleich der im anderen Signalweg durch das lineare Transversalfilter entstandenen Verzögerung verzögert werden, und zum anderen einen digitalen Speicher $(M_o)$ enthält, der die verzögerten Abtastwerte adressiert empfängt und an einem Eingang der Multiplikationsschaltung (40) digitale Daten erzeugt, die mit den Daten aus dem linearen Transversalfilter in Phase sind, die am anderen Eingang der Multiplikationsschaltung zur Verfügung stehen.

3. Demodulationsschaltung nach einem der Ansprüche 1 und 2, dadurch gekennzeichnet, dass der vom Taktgeber (50) durchgeführte Befehl zum Unterdrücken derjenigen Signalwerte am Ausgang der Multiplikationsschaltung dient, die den asymptotischen Werten der Funktion M entsprechen.

4. Demodulationsschaltung nach einem der Ansprüche 2 und 3, dadurch gekennzeichnet, dass die Anzahl N der Verzögerungsschaltungen des Transversalfilters geradzahlig ist, und dass der Taktgeber (50) den Verzögerungsschaltungen der ersten und zweiten Stufe zur Ermittlung des digitalen Wertes einen gleichen Arbeitstakt auferlegt, jedoch jeweils mit gegenseitiger Verschiebung über eine Halbperiode.

5. Demodulationsschaltung nach einem der Ansprüche 2 und 3, dadurch gekennzeichnet, dass die Anzahl N der Verzögerungsschaltungen des Transversalfilters ungeradzahlig ist, und dass der Taktgeber (50) den Verzögerungsschaltungen der ersten und zweiten Stufe zur Ermittlung des digitalen Wertes einen gleichen und synchronen Arbeitstakt auferlegt.

6. Demodulationsschaltung nach Anspruch 5, dadurch gekennzeichnet, dass die Verzögerungsschaltungen der zweiten Stufe zur Ermittlung des digitalen Wertes durch die ersten Verzögerungsschaltungen der ersten Stufe zur Ermittlung des digitalen Wertes gebildet werden.

7. Anwendung der Demodulationsschaltung nach einem der vorangehenden Ansprüche 1 bis 6 zur Verwirklichung einer digitalen Demodulationsstufe für das Chrominanzsignal eines Fernsehempfängers.

8. Fernsehempfänger, dadurch gekennzeichnet, dass er eine digitale Demodulationsschaltung für das Chrominanzsignal nach Anspruch 7 enthält.

**Claims**

1. A digital circuit for demodulating a frequency-modulated signal, comprising an analog-to-digital converter (10) for a signal to be processed, whose output is split into two parallel paths, a clock circuit (50), and an operator at which these two paths come together and which produces at its output a signal proportional to said frequency value, characterized in that, so as to determine the frequency of a signal whose frequency was subjected to a modulation in accordance with the relation
$$X(t) = A \cdot \sin (\omega_o t + \int_0^t f(t) \cdot dt + \varphi_o)$$
wherein $\omega_o$ is the pulsatance of the subcarrier and $f(t)$ is the modulation signal, said paths comprise a first determining stage (30) for the derivative
$$X'(t) = A \cdot (\omega_o + f(t)) \cdot \cos (\omega_o t + \int_0^t f(t) \cdot dt + \varphi_o)$$
of the input signal, for predetermined instants which succeed each other at a rate having a period T and a second determining stage (20) for the values of the function

$$M = 1/A \cdot \cos (\omega_o t + \int_o^t f(t) \cdot dt + \varphi_o)$$

at the same predetermined instants, and that said operator is a multiplying circuit (40) for multiplying the signals produced by these first and second stages (30) and (20), this multiplying circuit recovering a digital signal

$$X'(t) \cdot M = f(t) + \omega_o$$

which is proportional to the instantaneous frequency of the frequency-modulated input signal.

2. A circuit as claimed in claim 1, characterized in that the first stage (30) is a linear transversal filter having N delay circuits and that the second stage (20) comprises delay circuits ($R_d$) intended to produce samples of the signal X(t) which are delayed through a period equal to the delay caused in the other path by said linear transversal filter and also a digital memory ($M_o$) receiving said delayed samples as addresses and applying to an input of the multiplying circuit (40) digital data which are in-phase with the digital data coming from the linear transversal filter and are conveyed to the other input of this multiplying circuit.

3. A circuit as claimed in one of the claims 1 and 2, characterized in that the control effected by the clock circuit (50) is provided to cancel at the output of the multiplying circuit (40) the signal values which would correspond to the asymptotic values of the function M.

4. A circuit as claimed in one of the claims 2 and 3, characterized in that the number N of the delay circuits of the transversal filter is even, and that the clock circuit (50) imposes on the delay circuits of the first and the second digital value determining stage rates of operation which are identical but shifted through one half-cycle with respect to each other.

5. A circuit as claimed in one of the claims 2 and 3, characterized in that the number N of the delay circuits of the transversal filter is odd, and that the clock circuit (50) imposes on the delay circuits of the first and second digital value determining stages rates of operation which are identical and synchronous.

6. A circuit as claimed in claim 5, characterized in that the delay circuits of the first digital value determining stage are constituted by the first delay circuits of the first digital value determining stage.

7. The use of the circuit in accordance with any one of the claims 1 to 6 to realize a digital demodulation stage for the chrominance signal of a television receiver.

8. A television receiver, characterized in that it comprises a digital demodulation stage for the chrominance signal as claimed in claim 7.

E

CIRCUIT
D'HORLOGE

*50*

CONVERTISSEUR
A-N

*10*

CIRCUIT
DE
RETARD

*20*

CIRCUIT
DE
RETARD

*Rd*

CIRCUIT
DE
RETARD

FILTRE
TRANSVERSAL

*30*

MEMOIRE

*Mo*

CIRCUIT DE
MULTIPLICATION

*40*

S